# EUROPÄISCHE PATENTSCHRIFT

(11) **EP 4 178 101 B1**
(45) Veröffentlichungstag und Bekanntmachung des Hinweises auf die Patenterteilung: **07.05.2025**
(21) Anmeldenummer: 21206218.6
(22) Anmeldetag: 03.11.2021
(51) Int. Cl.: H02P 6/34, G05B 23/02, G06N 20/00, G06F 18/23211

(54) **SCHWINGUNGSBASIERTEN ZUSTANDSÜBERWACHUNG VON ELEKTRISCHEN ROTATORISCHEN MASCHINEN**
VIBRATION-BASED STATE MONITORING OF ELECTRIC ROTARY MACHINES
SURVEILLANCE DE L'ÉTAT DE MACHINES ÉLECTRIQUES TOURNANTES EN FONCTION DES VIBRATIONS

(43) Veröffentlichungstag der Anmeldung: 10.05.2023
(73) Patentinhaber: Siemens Aktiengesellschaft, 80333 München (DE)
(72) Erfinder: Brückel, Martin, 91052 Erlangen (DE); Pradhan, Pranita Rajan, 91058 Erlangen (DE)
(74) Vertreter: Siemens Patent Attorneys

(56) Entgegenhaltungen:
- CN-A- 113 591 989
- DE-A1- 102017 124 589
- DE-U1- 202017 005 070

## Beschreibung

Die Erfindung betrifft ein computerimplementiertes Verfahren zum Trainieren eines Modells zum Empfehlen von Schwellwerten von mindestens einer räumlichen Schwingungskomponente einer elektrischen rotatorischen Maschine.

Außerdem betrifft die Erfindung ein computerimplementiertes Verfahren zum Überwachen eines Zustandes einer elektrischen rotatorischen Maschine.

Darüber hinaus betrifft die Erfindung ein Computerprogrammprodukt mit Befehlen zum Ausführen der vorgenannten Verfahren, ein maschinenlesbares Speichermedium mit einem solchen Computerprogrammprodukt, das die vorgenannten Befehle trägt. Obendrein betrifft die Erfindung eine Sensor- und Recheneinrichtung zum Überwachen eines Zustandes einer elektrischen rotatorischen Maschine.

Bei der Zustandsüberwachung von elektrischen Antrieben, beispielsweise von Elektromotoren, insbesondere von Niederspannungsmotoren, und ihrer industriellen Anwendungen ist eine der wichtigsten Messgrößen die Vibration, da diese, sofern mit ausreichend guter Messtechnik und in ausreichender Nähe zu den Mechanischen Komponenten gemessen, einen guten Indikator für mögliche Fehler und Schadensfälle darstellt. Viele Geräte zur halb-/automatischen Zustandsüberwachung werten deshalb die Schwingungsdaten und das Schwingungsniveau generell aus, um Aussagen zum "Gesundheitszustand" des Antriebs zu treffen. Ein grundsätzliches Problem stellt hierbei dar, dass die Schwingungsmessung von vielen externen Faktoren abhängen kann, besonders wenn nicht direkt an den mechanischen Komponenten (z.B. Lagergehäuse) gemessen wird. Besonders hat der Lastzustand des Motors in einer vorgegebenen Applikation einen wesentlichen Einfluss auf die Schwingungsamplitude, wie auch die Drehzahl. Die gängigen Lösungen verwenden alleine die Schwingungsmessung zur Analyse und versuchen, auf Basis der Schwingungsmessung verschiedene Cluster / Schwingungspunkte zu unterscheiden, häufig ohne den exakten Betriebspunkt zu kennen.

Um aber auch bereits sehr kleine Änderungen der Schwingungsamplitude über längere Zeit und über verschiedene Lastzustände (Drehzahl und/oder Drehmoment werden variiert) der Anwendung hinweg erkennen zu können, ist es essenziell, die verschiedenen Lastzustände möglichst genau unterscheiden zu können und damit die einzelnen Schwingungsmessungen diesen zuzuordnen, um dann für jeweils die gleichen Betriebspunkte die Schwingungsmessungen über längere Zeit, z.B. über mehrere Monate hin zu vergleichen und auf Abweichungen zu überprüfen.

Bekannt ist eine Applikation, die mittels eines Sensors erfasste Motordaten verarbeitet, Drehmoment, Drehzahl und dreidimensionale Schwingungswerte berechnet und anzeigt. Mit dieser Applikation kann eine Schwellwertüberprüfung durchgeführt werden, wobei ein Benutzer diesen Schwellwert anpassen kann. Bei der Berechnung der Schwellwertempfehlung und der Überprüfung auf Überschreitung berücksichtigt die Applikation den Betriebspunkt nicht, sodass kleinere Änderungen vor allem bei einzelnen Betriebspunkten nicht erkannt werden können. Dies führt zu einer unzufriedenstellenden Schwellwertüberprüfung und somit zu einer schlechten Zustandsüberwachung.

CN 113 591 989 A offenbart ein Restlebensdauervorhersageverfahren eines Permanentmagnetsynchronmotors. Das Verfahren umfasst die Schritte: Ermitteln eines Dreiphasenstromungleichgewichtsgrads und/ oder eines elektromagnetischen Drehmomentungleichgewichtsgrads als einen Haupteinflussfaktor eines Motorausfalls und Aufbauen eines Restlebensdauermodells des Permanentmagnetsynchronmotors; Erhalten der Zeitsequenz des Dreiphasenstroms, des elektromagnetischen Drehmoments und des sekundären Einflussfaktors des Motorausfalls des Permanentmagnetsynchronmotors als einen Trainingssatz und Ausführen eines ARIMA-Modelltrainings; und gemäß dem ARIMA-Modell Vorhersagen von Werten des Dreiphasenstroms, des elektromagnetischen Drehmoments und des sekundären Einflussfaktors und Substituieren der Werte in das Restlebensdauermodell, um den Ausfallzeitpunkt des Permanentmagnetsynchronmotors zu erhalten.

DE 10 2017 124589 A1 offenbart ein Verfahren zum Auswerten eines Betriebszustandes eines Wasserfahrzeugs mit folgenden Schritten: Bereitstellen von historischen Messwerten in einer Datenbank, die mit einer Datenverarbeitungseinrichtung gekoppelt ist, wobei zumindest für einen Teil der historischen Messwerte jeweils ein historischer Messwert einem Betriebszustand zugeordnet ist; Erfassen, mittels einer Messeinrichtung, eines aktuellen Messwerts; Übertragen des aktuellen Messwerts von der Messeinrichtung an die Datenbank; Bestimmen, mittels eines Prozessors der Datenverarbeitungseinrichtung, von genutzten Betriebszuständen anhand der historischen Messwerte, die einem Betriebszustand zugeordnet sind; Zuordnen, mittels des Prozessors, des aktuellen Messwerts zu einem der genutzten Betriebszustände und Auswerten, mittels des Prozessors, des aktuellen Messwerts mit Bezug zu dem zugeordneten genutzten Betriebszustand. Weiterhin ist ein System zum Auswerten eines Betriebszustandes eines Wasserfahrzeugs vorgesehen.

DE 20 2017 005070 U1 offenbart ein Computersystem zur computerimplementierten Erkennung von Anomalien in Ereignisströmen aus einem zu überwachenden technischen System, wobei das Computersystem ein Offline-Modul und ein Online-Modul umfasst, das Offline-Modul einen Wechselpunkterkenner und eine Lernkomponente zum Lernen eines Normalmodells umfasst und das Online-Modul eine Anomalieerkennungs-Komponente umfasst, in einem Offline-Schritt unter Verwendung des Wechselpunkterkenners eine Identifizierung unterschiedlicher Betriebszustände aus Ereignisströmen des zu überwachenden technischen Systems erfolgt, auf deren Grundlage in der Lernkomponente für jeden gefundenen Betriebszustand eine Erstellung eines Normalmodells erfolgt, und in einem Online-Schritt die Anomalieerkennungs-Komponente auf der Grundlage des in der Lernkomponente erstellten mindestens einen Normalmodells in einem eingehenden Ereignisstrom anomales Verhalten des überwachten technischen Systems detektiert.

Um eine auf Schwellwertüberprüfung basierende Zustandsüberwachung zu verbessern, wird das eingangs genannte computerimplementierte Verfahren zum Trainieren eines Modells vorgeschlagen und weitergebildet, wobei erfindungsgemäß
- historische Daten bereitgestellt werden, wobei die historischen Daten Zeitreihen von mindestens zwei Betriebsparametern und von mindestens einer räumlichen Schwingungskomponente der elektrischen rotatorischen Maschine umfassen,
- in den historischen Daten Betriebsplateaus erkannt werden, wobei ein Betriebsplateau dadurch definiert ist, dass die mindestens zwei Betriebsparameter über einen vorgebbaren Zeitraum (zwischen 10 und 30 Min) konstant sind/bleiben,
- auf den erkannten Betriebsplateaus eine Clusteranalyse durchgeführt wird, um Betriebspunkten-Cluster zu erkennen, wobei verschiedene Betriebspunkten-Cluster verschiedene Betriebszustände der elektrischen rotatorischen Maschine definieren,
- für die definierten Betriebszustände zu empfehlende Schwellwerte für die mindestens eine räumliche Schwingungskomponente ermittelt werden. (unterschiedliche Empfehlungen für unterschiedliche Betriebszustände),
- die definierten Betriebszustände und die für die definierten Betriebszustände zu empfehlenden Schwellwerte bereitgestellt werden.

Bei einer Ausführungsform kann es vorgesehen sein, dass für jeden Betriebspunkten-Cluster ein Schwerpunkt (z.B. durch Berechnen eines Cluster-Mittelwerts) geschätzt wird.

Bei einer Ausführungsform kann es vorgesehen sein, dass für jeden Betriebszustand ein zu empfehlender Schwellwert berechnet wird.

Bei einer Ausführungsform kann es vorgesehen sein, dass die historischen Daten Zeitreihen von zwei oder drei räumlichen Schwingungskomponenten umfassen, wobei für die definierten Betriebszustände zu empfehlende Schwellwerte für die zwei oder drei räumlichen Schwingungskomponenten ermittelt werden. Dabei kann beispielsweise ein Bayesian-Gaussian-Mixture-Model (BGMM) auf die Zeitreihe der räumlichen Schwingungskomponente angewandt werden.

Bei einer Ausführungsform kann es vorgesehen sein, dass unterschiedlichen Betriebspunkten-Clustern unterschiedliche Kennzeichnung zugeordnet wird **(z.B.** Zahl, Nummer, Farbe etc.).

Bei einer Ausführungsform kann es vorgesehen sein, dass unterschiedlichen Betriebsplateaus unterschiedliche Kennzeichnung zugeordnet wird (Zahl, Nummer, Farbe etc.)

Bei einer Ausführungsform kann es vorgesehen sein, dass zwei Betriebsplateaus **(z.B.** dann und nur dann) unterschiedlich sind, wenn zumindest einer der mindestens zwei Betriebsparameter unterschiedlich ist.

Bei einer Ausführungsform kann es vorgesehen sein, dass die Betriebsparameter Drehzahl und Schlupffrequenz sind.

Bei einer Ausführungsform kann es vorgesehen sein, dass die Zeitreihen der historischen Daten von bis zu einem Monat zurückgehen.

Weitere den Betrieb der elektrischen rotatorischen Maschine betreffende Parameter sind: Temperatur, elektrische Statorfrequenz, Drehmoment, elektrische Leistung und elektrische Energie, Effektivwerte der räumlichen Schwingungskomponenten.

Zum Verbessern der Zustandsüberwachung wird das eingangs genannte computerimplementierte Verfahren zum Zustandsüberwachen einer elektrischen rotatorischen Maschine erfindungsgemäß derart weitergebildet, dass
- Ist-Daten bereitgestellt werden, wobei die Ist-Daten Zeitreihen von mindestens zwei Betriebsparametern und von mindestens einer räumlichen Schwingungskomponente der elektrischen rotatorischen Maschine umfassen,
- in den Ist-Daten Betriebsplateaus erkannt werden, wobei ein Betriebsplateau dadurch definiert ist, dass die mindestens zwei Betriebsparameter über einen vorgebbaren Zeitraum, beispielsweise zwischen 10 und 30 Minuten, insbesondere 15 Minuten, konstant sind/bleiben,
- ein wie oben beschrieben trainiertes Modell bereitgestellt wird,
- die erkannten Betriebsplateaus den durch das trainierte Modell definierten Betriebszuständen zugeordnet werden, um (den erkannten Betriebsplateaus entsprechende) Zeitreihe/Werte der mindestens einen räumlichen Schwingungskomponente auf die durch das trainierte Modell definierten Betriebszustände abbilden zu können,
- überprüft wird, ob Werte der mindestens einen räumlichen Schwingungskomponente einen durch das trainierte Modell empfohlenen Schwellwert überschreiten,
- falls die Werte der mindestens einen räumlichen Schwingungskomponente den Schwellwert überschreiten, eine Warnmeldung nach einem vorbestimmbaren Kriterium ausgegeben wird.

Bei einer Ausführungsform kann es vorgesehen sein, dass jedes Plateau jeweils einem Zustand zugeordnet wird, z.B. durch Berechnen einer euklidischen Distanz zwischen dem Datenpunkt und dem Schwerpunkt des Zustandes.

Bei einer Ausführungsform kann es vorgesehen sein, dass, wenn zumindest drei nacheinander folgende Werte der mindestens einen räumlichen Schwingungskomponente den Schwellwert überschreiten, eine Warnmeldung ausgegeben wird.

Bei einer Ausführungsform kann es vorgesehen sein, dass die Ist-Daten Zeitreihen von zwei oder drei räumlichen Schwingungskomponenten umfassen, wobei überprüft wird, ob Werte der zwei oder drei räumlichen Schwingungskomponenten entsprechende durch das trainierte Modell empfohlene Schwellwerte überschreiten.

Bei einer Ausführungsform kann es vorgesehen sein, dass für jeden Wert der mindestens einen räumlichen Schwingungskomponente, der den Schwellwert überschreitet, für jede räumliche Schwingungskomponente ein Effektivwert berechnet wird und aus den berechneten Effektivwerten ein geometrisches Mittel berechnet wird, wobei, wenn das geometrische Mittel einen vorgegebenen Wert, beispielsweise 4 mm/s, überschreitet, die Warnmeldung ausgegeben wird.

Bei einer Ausführungsform kann es vorgesehen sein, dass die Warnmeldung eine Anzahl der Überschreitungen und dazugehörige Zeitstempel umfasst.

Bei einer Ausführungsform kann es vorgesehen sein, dass die Zeitreihen der Ist-Daten von bis zu zwei Tagen zurückgehen.

Bei einer Ausführungsform kann es vorgesehen sein, dass die Ist-Daten gespeichert werden und in vorgegebenen Zeitabständen, beispielsweise jeden Monat, das bereitgestellte Modell gemäß dem oben beschriebenen Trainings-Verfahren neutrainiert wird.

Ein weiterer Aspekt der vorliegenden Erfindung ist die eingangs genannte Sensor- und Recheneinrichtung, die erfindungsgemäß derart weitergebildet ist, dass sie dazu eingerichtet ist, auf den Betrieb der elektrischen rotatorischen Maschine bezogene Daten an der elektrischen rotatorischen Maschine zu erfassen, wobei die Daten Zeitreihen von mindestens zwei Betriebsparametern und von mindestens einer räumlichen Schwingungskomponente der elektrischen rotatorischen Maschine umfassen, wobei die Sensor- und Recheneinrichtung Befehle umfasst, die beim Ausführen durch die Sensor- und Recheneinrichtung diese veranlassen, das oben beschriebene Trainings-Verfahren und/oder das oben beschriebene Zustandsüberwachungs-Verfahren auszuführen.

Bei einer Ausführungsform kann es vorgesehen sein, dass die elektrische rotatorische Maschine als ein Elektromotor, insbesondere als ein Niederspannungsmotor ausgebildet ist.

Bei einer Ausführungsform kann es vorgesehen sein, dass die elektrische rotatorische Maschine sich im Betrieb unter einer zeitlich variablen Last befindet, wobei vorzugsweise die zeitlich variable Last durch zeitlich variierendes Drehmoment oder zeitlich variierende Drehzahl charakterisiert ist.

Bei einer Ausführungsform kann es vorgesehen sein, dass die Sensor- und Recheneinrichtung dazu eingerichtet ist, berechnete Daten (Schwingungswerte, Drehmoment, Drehzahl) zu visualisieren.

Der Erfindung liegt die Erkenntnis zugrunde, dass die schwellwertbasierte Zustandsüberwachung verbessert werden kann, wenn zwischen den verschiedenen auftretenden Betriebspunkten unterschieden und für jeden der gefundenen Betriebspunkte eigene Schwingungsschwellwerte ermittelt werden.

Die ermittelten Schwingungsschwellwerte können möglichst nahe am Erwartungswert der Schwingungsamplitude liegen und die die Effektivwerte (RMS Werte für Root Mean Square) der Schwingungsmessung nach oben beschränken. Unter dem Effektivwert wird in der Elektrotechnik der quadratische Mittelwert einer zeitlich veränderlichen physikalischen Größe verstanden. Gleichzeitig sollen die Grenzwerte aber nicht zu klein gewählt sein, um die Anzahl der Fehlalarme zu reduzieren und nur bei "relevanten" Schwellwertüberschreitungen zu reagieren.

Dies kann, wie oben beschrieben dadurch erreicht werden, dass sowohl im Wertebereich durch Clustering nach den physikalischen Parametern nach häufigen Betriebspunkten gefiltert wird wie auch gleichzeitig im Zeitbereich durch das Plateau-Erkennungsverfahren. Dadurch wird es möglich, für die häufigsten und gleichzeitig zeitlich konstanten Betriebspunkte spezifische Schwellwerte für die Schwingung anzugeben, sodass auch bereits kleine Sprünge oder Veränderungen des Schwingungslevels über einen mittleren Zeitraum (< 1 Monat) bereits erkannt werden können, wobei gleichzeitig äußere Einflüsse in Form von kurzfristigen Oszillationen des Schwingungspegels herausgefiltert werden und abschließend die Kritikalität durch Abgleich mit einer Norm sichergestellt werden kann. Als Vorteile ergeben sich eine bessere Erkennung von Fehlerzuständen in der elektrischen rotatorischen Maschine und somit auch in der Anwendung, da äußere Abhängigkeiten und/oder Störgrößen besser herausgefiltert werden können. Gleichzeitig kann die Anzahl von Fehlermeldungen reduziert werden, da erst bei einer deutlich erkennbaren Kritikalität eine Meldung erzeugt werden kann, gleichzeitig aber auch bei Langzeitbetrieb mit Schwingungen über den Normwerten kleinere Änderungen über die Zeit erkannt und gemeldet werden können.

Hierdurch ist es möglich, auch bei Antrieben mit stärkeren Schäden oder vibrationsstarken Betriebspunkten Verschlechterungen im "Gesundheitszustand" festzustellen, sodass eine umfassendere Inspektion vor Ort eingeleitet werden kann bzw. die Daten manuell untersucht werden können.

Die Erfindung samt weiteren Vorteilen ist im Folgenden anhand beispielhafter Ausführungsformen näher erläutert, die in der Zeichnung veranschaulicht sind. In dieser zeigt
- FIG 1: ein Ablaufdiagramm eines computerimplementierten Trainingsverfahrens,
- FIG 2: ein Ergebnis einer Plateau-Erkennung,
- FIG 3: ein Ergebnis einer Clusteranalyse,
- FIG 4: unterschiedliche Schwellwertempfehlungen für unterschiedliche Betriebszustände,
- FIG 5: ein System zum Ausführen des Trainingsverfahrens der FIG 1,
- FIG 6: ein Ablaufdiagramm eines computerimplementierten Zustandsüberwachungsverfahrens,
- FIG 7: ein Ergebnis einer Zuordnung der Ist-Betriebsplateaus den Betriebszuständen aus trainiertem Modell, und
- FIG 8: eine Sensor- und Recheneinrichtung zum Überwachen eines Zustandes einer elektrischen rotatorischen Maschine.

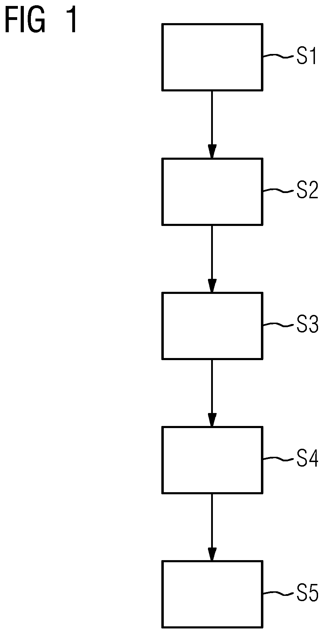

FIG 1 zeigt ein Ablaufdiagramm eines computerimplementierten Verfahrens, das dem erfindungsgemäßen Verfahren entspricht. Bei dem Verfahren wird ein Modell trainiert, das Schwellwerten mindestens einer räumlichen Schwingungskomponente einer elektrischen rotatorischen Maschine empfiehlt.

In einem Schritt S1 des Trainingsverfahrens werden historische Daten bereitgestellt. Die historischen Daten umfassen Zeitreihen von mindestens zwei Betriebsparametern und von mindestens einer räumlichen Schwingungskomponente der elektrischen rotatorischen Maschine. Die elektrische rotatorische Maschine kann z.B. ein Elektromotor, insbesondere ein Niederspannungsmotor sein.

Die Betriebsparameter sind vorzugsweise Drehzahl und Schlupffrequenz.

Die Zeitreihen der historischen Daten gehen beispielsweise von bis zu einem Monat zurück und bieten somit einen guten Überblick über das Verhalten der elektrischen rotatorischen Maschine in der jüngsten Vergangenheit. Der Zeitraum von einem Monat ist hier keineswegs als eine Einschränkung zu verstehen - einerseits können auch ältere Daten verwendet werden, falls sie zur Verfügung stehen, andererseits kommen auch kürzere Zeitintervalle in Betracht, wenn es sinnvoll ist, das Modell öfter neu zu trainieren (siehe unten).

Weitere den Betrieb der elektrischen rotatorischen Maschine betreffende Parameter können Temperatur, elektrische Statorfrequenz, Drehmoment, elektrische Leistung und elektrische Energie, Effektivwerte der räumlichen Schwingungskomponenten etc. umfassen.

Alle Betriebsparameter können in Gruppen zusammengefasst werden. Die Betriebsparameter wie Temperatur und elektrische Statorfrequenz werden nicht selten als Hochfrequenz KPIs (engl. Key Performance Identicator) bezeichnet, weil sie im Betrieb der Maschine in etwa jede Minute gemessen werden. Andere Betriebsparameter, wie z.B. Drehmoment, elektrische Leistung und elektrische Energie werden als Niederfrequenz KPIs bezeichnet. Sie werden seltener - in etwa jede dritte Minute - erfasst.

In einem weiteren Schritt S2 werden in den historischen Daten Betriebsplateaus erkannt. Ein Betriebsplateau ist dadurch definiert, dass die mindestens zwei Betriebsparameter über einen vorgebbaren Zeitraum, z.B. zwischen 10 und 30 Minuten, insbesondere 15 Minuten lang, konstant sind/bleiben. Die Werte 10, 15, 30 Minuten dienen als Richtwerte und sind im Allgemeinen motortypabhängig. Es kann beispielsweise durchaus 30 Minuten dauern, bis ein Motor seinen geplanten Betriebszustand erreicht hat.

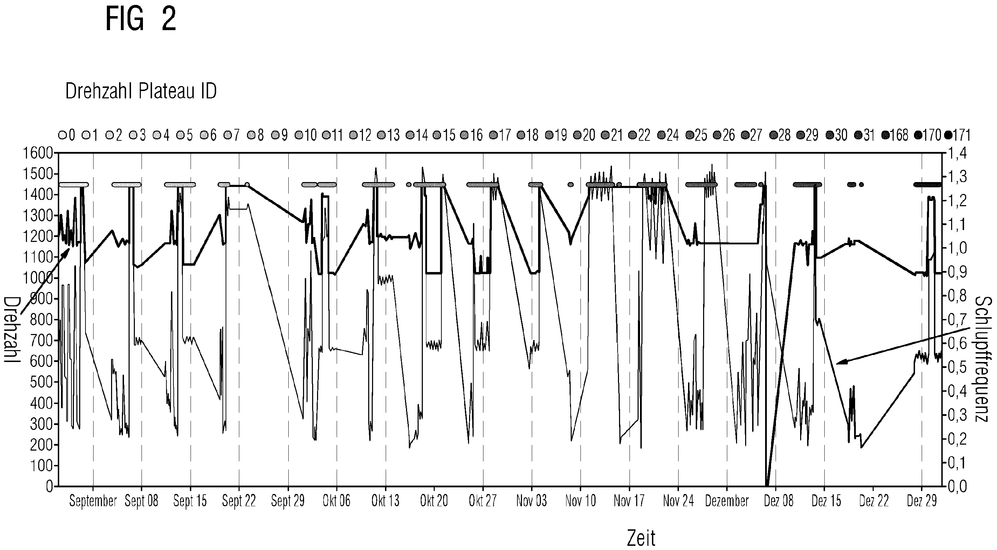

Ein Beispiel einer Plateau-Erkennung ist in FIG 2 veranschaulicht. Auf der Abszissenachse ist die Zeit vom September bis Ende Dezember - also ca. vier Monate - abgetragen. Auf den Ordinatenachsen sind jeweils die Drehzahl und die Schlupffrequenz abgetragen.

FIG 2 lässt erkennen, dass mehrere unterschiedliche Betriebsplateaus erkannt worden sind. Die Plateaus sind dann unterschiedlich, wenn sich zumindest einer der mindestens zwei Betriebsparameter - hier Drehzahl und Schlupffrequenz -von dem anderen unterschiedet.

FIG 2 lässt auch erkennen, dass unterschiedlichen Betriebsplateaus unterschiedliche Kennzeichnung zugeordnet werden kann. Im vorliegenden Beispiel sind die Plateaus durchnummeriert und mit verschiedenen Farben - hier allerdings aufgrund der schwarzweißen Darstellung schlecht erkennbar - aufgetragen.

In einem Schritt S3 wird auf den erkannten Betriebsplateaus eine Clusteranalyse durchgeführt, um Betriebspunkten-Cluster zu erkennen. Hierzu kann beispielsweise ein Machine-Learning-Algorithmus, z.B. DBSCAN (engl. Density-based spatial clustering of applications with noise) verwendet werden.

Verschiedene Betriebspunkten-Cluster definieren verschiedene Betriebszustände der elektrischen rotatorischen Maschine. Insbesondere sollen für alle Punkte eines Betriebspunkten-Clusters die gleichen Schwellwerte für eine (oder mehrere) Schwingungskomponente(n) gelten.

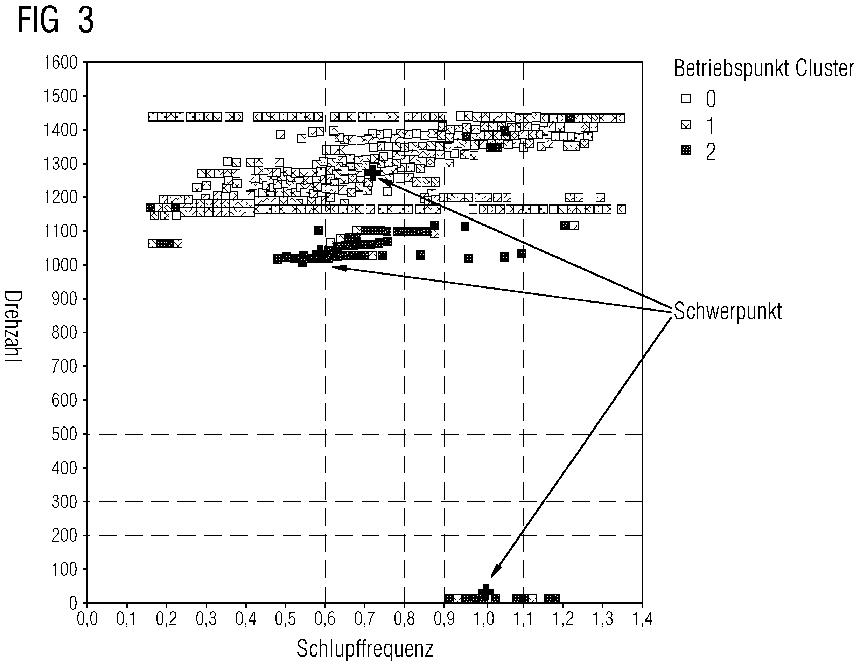

Ein Beispiel eines Ergebnisses einer Clusteranalyse ist in FIG 3 veranschaulicht. Auf der Abszissenachse ist die Schlupffrequenz und auf der Ordinatenachse ist eine Drehzahl abgetragen. Erkannt wurden drei Betriebspunkten-Cluster. Unterschiedlichen Betriebspunkten-Clustern kann unterschiedliche Kennzeichnung zugeordnet werden (Zahl, Nummer, etc.). FIG 3 lässt erkennen, dass für jeden Betriebspunkten-Cluster ein Schwerpunkt ermittelt werden. Dies kann beispielsweise durch Berechnen eines Cluster-Mittelwerts erfolgen.

In einem Schritt S4 werden für die definierten Betriebszustände, vorzugsweise für jeden definierten Betriebszustand eine Schwellwertempfehlung für die mindestens eine räumliche Schwingungskomponente ermittelt. Es versteht sich, dass es unterschiedliche Empfehlungen für unterschiedliche Betriebszustände geben kann.

Um Empfehlung(en) zu ermitteln, kann beispielsweise ein Bayesian-Gaussian-Mixture-Model auf die Zeitreihe der räumlichen Schwingungskomponente angewandt werden.

Der ermittelte Schwellwert ist vorzugsweise so, dass sie möglichst nahe, vorzugsweise innerhalb von z.B. drei Standardabweichungen, am Erwartungswert der entsprechende Schwingungsamplitude liegt und den RMS-Wert (RMS für Root Mean Square) der Schwingungsmessung nach oben beschränken soll.

Zweckmäßig kann es sein, wenn für jeden Betriebszustand ein zu empfehlender Schwellwert berechnet wird.

Wenn die historischen Daten Zeitreihen von zwei oder drei räumlichen Schwingungskomponenten umfassen, können entsprechende Schwellwertempfehlungen für die definierten Betriebszustände auch für weitere räumliche Schwingungskomponenten ermittelt werden.

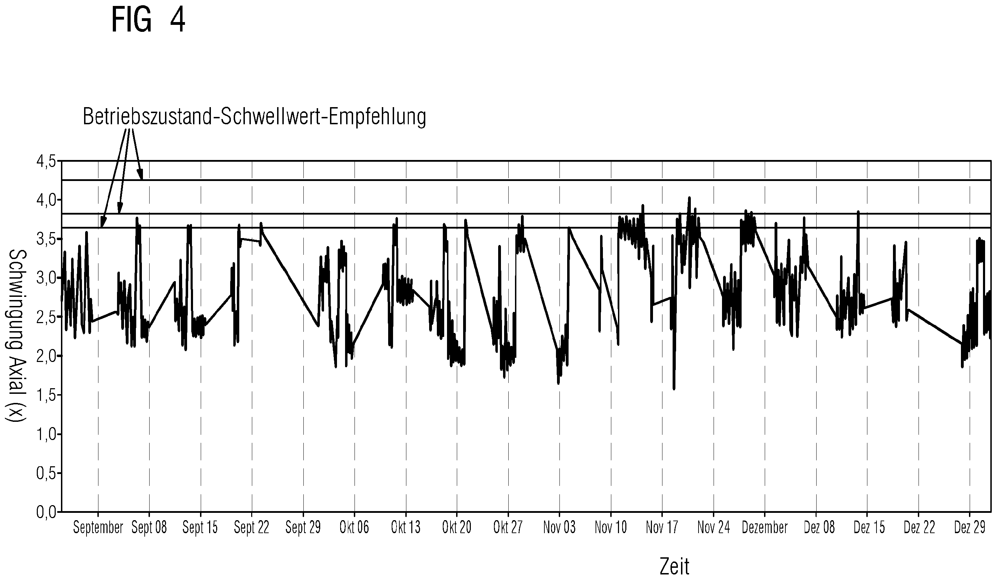

FIG 4 veranschaulicht drei Schwellwertempfehlungen für die X-Schwingungskomponente für drei Betriebszustände, die in FIG 3 zu erkennen sind. Auf der Abszissenachse ist die Zeit abgetragen. Auf der Ordinatenachse ist die Axialschwingung (X) abgetragen.

In einem Schritt S5 werden die definierten Betriebszustände und die für die definierten Betriebszustände zu empfehlenden Schwellwerte bereitgestellt. Somit ist das Modell trainiert und kann verwendet werden.

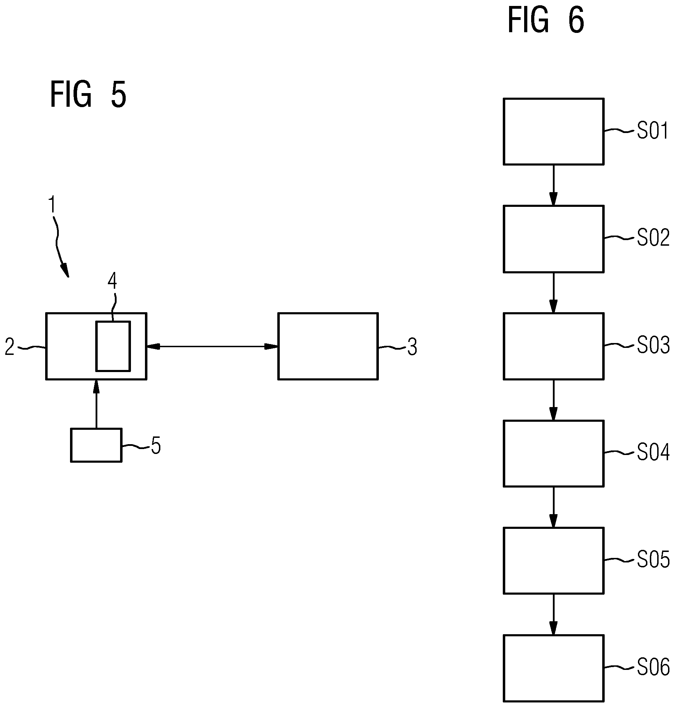

FIG 5 zeigt schematisch ein System 1, das zum Ausführen des oben beschriebenen Trainingsverfahrens geeignet ist. Das System 1 umfasst ein Speichermedium 2 zum Speichern, z.B. Zwischenspeichern, von maschinenausführbaren Komponenten und eine Prozessoreinheit 3, z.B. einen oder mehrere CPUs, die mit dem Speichermedium 2 operativ gekoppelt werden können, um die maschinenausführbaren Komponenten auszuführen.

Das Speichermedium 2 umfasst maschinenausführbare Befehle 4, die durch die Prozessoreinheit abgearbeitet werden können, und, wenn sie abgearbeitet werden, das oben beschriebene Lernverfahren basierend auf den historischen Daten 5 ausführt. Die historischen Daten können dem Speichermedium 2 zur Verfügung gestellt werden oder auf diesem gespeichert sein. Die Prozessoreinheit 3 kann auch eingerichtet sein, die historischen Daten 5 aus einer Datenbank herunterzuladen.

FIG 6 zeigt ein Ablaufdiagramm eines computerimplementierten Verfahrens, das dem erfindungsgemäßen Verfahren zum Überwachen eines Zustandes einer elektrischen rotatorischen Maschine entspricht.

In einem Schritt S01 werden Ist-Daten bereitgestellt, wobei die Ist-Daten Zeitreihen von mindestens zwei Betriebsparametern und von mindestens einer räumlichen Schwingungskomponente der elektrischen rotatorischen Maschine umfassen.

Wie bei dem bereits erörterten Trainingsverfahren sind die Betriebsparameter vorzugsweise die Drehzahl und die Schlupffrequenz. Die elektrische rotatorische Maschine kann ein Elektromotor, insbesondere ein Niederspannungsmotor sein.

Die Ist-Daten können außerdem Zeitreihen von zwei oder drei räumlichen Komponenten umfassen (X, Y und Z). Auch Zeitreihen von anderen Hoch- und/oder Niederfrequenz-KPIs können in den Ist-Daten enthalten sein.

Die Zeitreihen der Ist-Daten gehen für gewöhnlich von bis zu zwei Tagen zurück aber nicht länger. Sie können auch nur Daten umfassen, die in den letzten 24 Stunden der Betriebszeit der Maschine erfasst wurden.

In einem Schritt S02 werden in den Ist-Daten Betriebsplateaus erkannt, wobei ein Betriebsplateau dadurch definiert ist, dass die mindestens zwei Betriebsparameter über einen vorgebbaren Zeitraum, beispielsweise zwischen 10 und 30 Minuten, insbesondere 15 Minuten konstant sind/bleiben. Die Erkennung der Betriebsplateaus in den Ist-Daten findet auf ähnliche Art und Weise statt, wie die Erkennung der Betriebsplateaus in den historischen Daten.

In einem Schritt S03 wird ein wie oben beschrieben trainiertes Modell bereitgestellt. Das Modell kann auch vor Ort, beispielsweise an der Maschine zuerst trainiert werden, um es gleich auf Echtzeitsituation bzw. auf den laufenden Betrieb der Maschine anzuwenden.

In einem Schritt S04 werden die erkannten Betriebsplateaus den durch das trainierte Modell definierten Betriebszuständen zugeordnet. Die Zuordnung wird zu dem Zweck durchgeführt, um den erkannten Betriebsplateaus entsprechende Zeitreihen bzw. Werte der mindestens einen räumlichen Schwingungskomponente auf die durch das trainierte Modell definierten Betriebszustände abzubilden.

Dabei kann jedes Ist-Betriebsplateau jeweils einem BetriebsZustand aus dem Modell zugeordnet werden. Dies kann beispielsweise durch Berechnen einer euklidischen Distanz zwischen dem Ist-Betriebsplateau und dem Schwerpunkt des Betriebs-Zustandes aus dem Modell erfolgen.

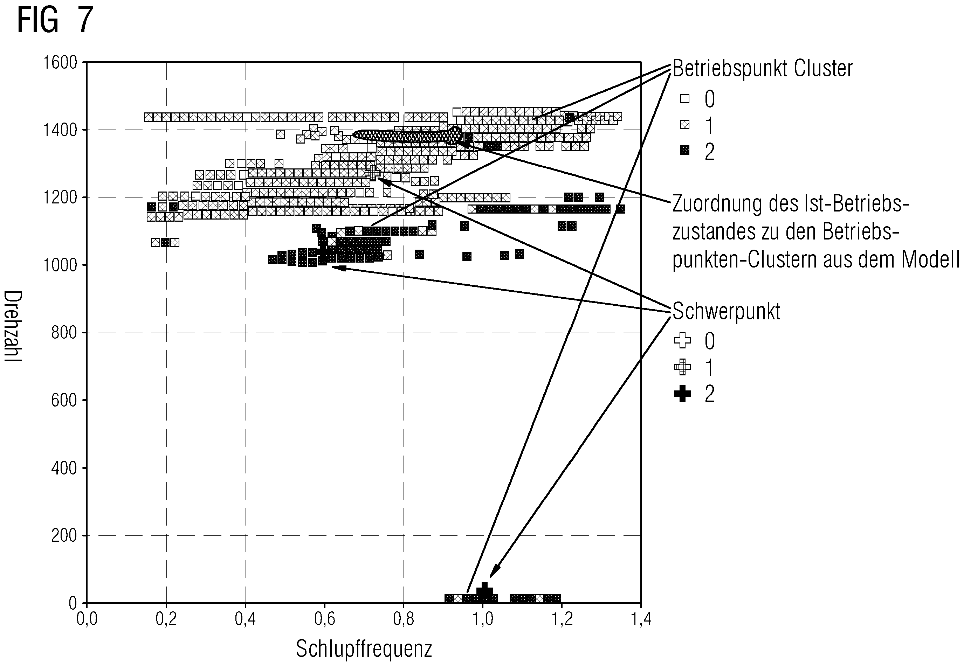

Ein Ergebnis einer solchen Zuordnung ist beispielhaft in FIG 7 gezeigt. FIG 7 lässt Betriebszustände erkennen, die im Zuge der Clusteranalyse der historischen Daten definiert worden sind (vgl. FIG 3). Diese sind mit quadratischen Punkten gekennzeichnet. Die Betriebsplateaus aus den Ist-Daten sind als runde (orangefarbene) Punkte zu erkennen. Diese können z.B. auf Basis einer kleineren euklidischen Distanz zu dem entsprechenden Schwerpunkt dem Betriebspunkten-Cluster bzw. dem Betriebszustand "0" zugeordnet werden.

Nach der Zuordnung kann nun der Schwellenwertvorschlag des Modells, der für jeden Betriebszustand während des Trainings erhalten wurde, für die Suche nach den Schwellenwertüberschreitungen verwendet werden.

In einem Schritt S05 wird also überprüft, ob Werte (aus der Zeitreihe) der mindestens einen räumlichen Schwingungskomponente einen durch das trainierte Modell empfohlenen Schwellwert überschreiten.

In einem Schritt S06 wird eine Warnmeldung nach einem vorbestimmbaren Kriterium ausgegeben, falls die Werte der mindestens einen räumlichen Schwingungskomponente den Schwellwert überschreiten.

Um die Anzahl der möglichen Warnmeldungen zu reduzieren, kann zunächst zwischen "oszillierenden" und "nicht-oszillierenden" (Ist-)Betriebsplateaus unterschieden werden. Dabei wird ein Betriebsplateau als nicht-oszillierend bezeichnet, wenn der Wert der Schlupffrequenz innerhalb des Betriebsplateaus nicht sehr stark variiert, beispielsweise seine Standardabweichung kleiner als 0,5 ist. Die Überprüfung findet dann nur in den nicht-oszillierenden Betriebsplateaus statt.

Darüber hinaus kann eine Warnmeldung nur dann ausgegeben werden, wenn zumindest drei nacheinander folgende Werte (drei nacheinander folgende Datenpunkte in der Zeitreihe) der mindestens einen räumlichen Schwingungskomponente den Schwellwert überschreiten. Wenn alle drei Minuten eine Messung durchgeführt wird, entspricht das einer neunminütigen Überschreitung des Schwellwertes.

Wie bereits erörtert können die Ist-Daten Zeitreihen von zwei oder drei räumlichen Schwingungskomponenten - X-, Y-, und Z-Komponenten - umfassen. Dabei kann überprüft wird, ob Werte der zwei oder drei räumlichen Schwingungskomponenten entsprechende durch das trainierte Modell empfohlene Schwellwerte überschreiten.

In diesem Fall kann, wenn eine der z.B. drei räumlichen Schwingungskomponenten den Schwellwert überschreitet, ein Effektivwert (RMS-Wert) berechnet werden, um aus den berechneten Effektivwerten ein geometrisches Mittel zu berechnen. Wenn das geometrische Mittel einen vorgegebenen Wert, beispielsweise 4 mm/s, überschreitet, wird die Warnmeldung ausgegeben. Der Wert von 4mm/s entspricht einem Wert für mittelgroße Maschinen aus DIN ISO 10816-3.

Die Warnmeldung kann eine Anzahl der Überschreitungen und dazugehörige Zeitstempel umfassen.

Wenn die elektrische rotatorische Maschine über längere Zeit, beispielsweise über mehrere Monate oder Jahre betrieben wird, kann es zweckmäßig sein, das Modell nach oder einzutrainieren. Dabei kann es vorgesehen sein, dass die Ist-Daten gespeichert werden und, in vorgegebenen Zeitabständen, beispielsweise jeden Monat, das bereitgestellte Modell wie oben beschrieben anhand "neuer" historischer Daten neutrainiert wird.

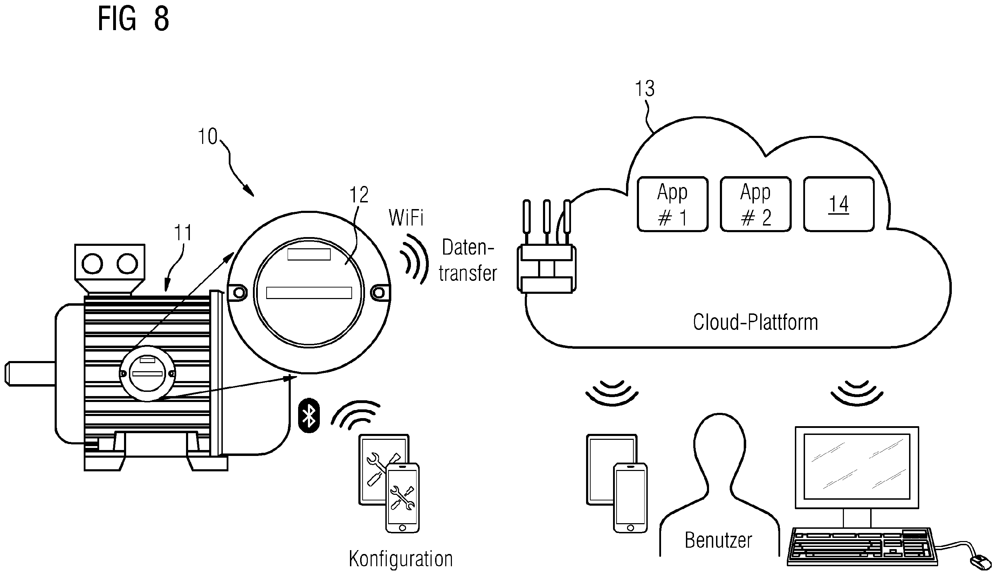

FIG 8 zeigt eine Sensor- und Recheneinrichtung 10 zum Überwachen eines Zustandes einer elektrischen rotatorischen Maschine 11. Die Maschine ist als ein Elektromotor ausgebildet. Die Sensor- und Recheneinrichtung umfasst eine Sensoreinrichtung 12, die an dem Elektromotor 11 angeordnet ist. Beispielsweise kann die Sensoreinrichtung 12 an Kühlrippen des Motorgehäuses befestigt sein.

Der Elektromotor 11 kann als ein Niederspannungsmotor ausgeführt sein.

Der Elektromotor 11 befindet sich im Betrieb unter einer zeitlich variablen Last, wobei vorzugsweise die zeitlich variable Last durch zeitlich variierendes Drehmoment oder zeitlich variierende Drehzahl charakterisiert ist.

Die Sensoreinrichtung 12, die als eine batteriebetriebene Smartbox ausgeführt werden kann, ist dazu eingerichtet, auf den Betrieb des Elektromotors bezogene Daten zu erfassen. In dem dargestellten Beispiel erfasst die Sensoreinrichtung 12 viele der Daten indirekt. Beispielsweise können Schwingungen der Lager nicht direkt, sondern über das Gehäuse empfangen werden. Dies betrifft auch die Temperatur des Läufers etc.

Die erfassten Daten können in Form von Zeitreihen vorliegen. Diese umfassen Zeitreihen von mindestens zwei Betriebsparametern (z.B. Drehzahl und Schlupffrequenz) und von mindestens einer räumlichen Schwingungskomponente des Elektromotors.

Die Sensoreinrichtung 12 kann vor Ort, z.B. über eine kurzreichweitige Funkverbindung, z.B. über eine Bluetooth-Verbindung, konfiguriert werden.

Die Sensoreinrichtung 12 verfügt über eine Datenschnittstelle, z.B. WiFi, die einen Datentransfer an eine Recheneinrichtung 13 ermöglicht.

Die Recheneinrichtung 13 kann z.B. als eine cloudbasierte Plattform ausgebildet sein, die verschiedene Dienste App #1, App #2, ... zur Überwachung und/oder Verwaltung von elektrischen rotatorischen Maschinen, z.B. von Elektromotoren durch Benutzer anbietet.

Die Sensor- und Recheneinrichtung 10, vorzugsweise die Recheneinrichtung 13 umfasst Befehle 14, die beim Ausführen durch die Sensor- und Recheneinrichtung diese veranlassen, ein oben beschriebenes Trainingsverfahren und/oder ein oben beschriebenes Zustandsüberwachungsverfahren auszuführen.

Die Befehle 14 können als Teil einer App ausgebildet sein.

Mit anderen Worten ist die Sensor- und Recheneinrichtung 10 dazu eingerichtet, Antriebsdaten (Motordaten) zu erfassen und basierend auf den Antriebsdaten Schwingungswerte zu berechnen und anhand der berechneten Schwingungswerte eine auf Schwellwertüberprüfung basierende Zustandsüberwachung des elektrischen Antriebs durchzuführen. Hierzu weist die Sensor- und Recheneinrichtung 10 einen auf der Sensor- und Recheneinrichtung ausführbaren, trainierten und lernfähigen Algorithmus 14 auf, wobei der Algorithmus 14, wenn er auf der Sensor- und Recheneinrichtung ausgeführt wird:
- basierend auf den Antriebsdaten zumindest zwei unterschiedliche Betriebszustände des elektrischen Antriebs ermittelt,
   und
- für jeden Betriebspunkt basierend auf den berechneten Schwingungswerten einen Schwingungsschwellwert ermittelt,
- die auf Schwellwertüberprüfung basierende Zustandsüberwachung des elektrischen Antriebs unter Berücksichtigung der ermittelten Schwingungsschwellwerte durchführt.

FIG 8 zeigt eine Ausführungsform der Sensor- und Recheneinrichtung 10, die als ein System ausgeführt ist, die sowohl Shopfloor-Komponenten, z.B. die als Smartbox ausgeführte Sensoreinrichtung 12, als auch Cloud-Komponenten, z.B. die Recheneinrichtung 13, umfasst.

Die Sensor- und Recheneinrichtung 10 kann aber auch als eine Baueinheit ausgeführt sein, die sowohl die Sensorik umfasst, um die Daten zu erfassen, als auch die Rechenressourcen zur Verfügung stellt, um den Algorithmus 14 auszuführen und die Daten zu verarbeiten.

Figuren 2 bis 4, 7 und 8 machen es deutlich, die Sensor- und Recheneinrichtung 10 dazu eingerichtet ist, berechnete Daten (Schwingungswerte, Drehmoment, Drehzahl) zur Visualisierung aufzubereiten oder zu visualisieren.

## Patentansprüche

1. Computerimplementiertes Verfahren zum Trainieren eines Modells zum Empfehlen von Schwellwerten von mindestens einer räumlichen Schwingungskomponente einer elektrischen rotatorischen Maschine, wobei
- historische Daten bereitgestellt werden (S1), wobei die historischen Daten Zeitreihen von mindestens zwei Betriebsparametern und von mindestens einer räumlichen Schwingungskomponente der elektrischen rotatorischen Maschine umfassen, **dadurch gekennzeichnet, dass**
- in den historischen Daten Betriebsplateaus erkannt werden (S2), wobei ein Betriebsplateau dadurch definiert ist, dass die mindestens zwei Betriebsparameter über einen vorgebbaren Zeitraum konstant sind,
- auf den erkannten Betriebsplateaus eine Clusteranalyse durchgeführt wird (S3), um Betriebspunkten-Cluster zu erkennen, wobei verschiedene Betriebspunkten-Cluster verschiedene Betriebszustände der elektrischen rotatorischen Maschine definieren,
- für die definierten Betriebszustände zu empfehlende Schwellwerte für die mindestens eine räumliche Schwingungskomponente ermittelt werden (S4),
- die definierten Betriebszustände und die für die definierten Betriebszustände zu empfehlenden Schwellwerte bereitgestellt werden (S5).

2. Verfahren nach Anspruch 1, wobei für jeden Betriebspunkten-Cluster ein Schwerpunkt geschätzt wird.

3. Verfahren nach Anspruch 1 oder 2, wobei die historischen Daten Zeitreihen von zwei oder drei räumlichen Schwingungskomponenten umfassen, wobei für die definierten Betriebszustände zu empfehlende Schwellwerte für die zwei oder drei räumlichen Schwingungskomponenten ermittelt werden.

4. Verfahren nach einem der Ansprüche 1 bis 3, wobei die Betriebsparameter Drehzahl und Schlupffrequenz sind.

5. Computerimplementiertes Verfahren zum Überwachen eines Zustandes einer elektrischen rotatorischen Maschine, wobei
- Ist-Daten bereitgestellt werden (S01), wobei die Ist-Daten Zeitreihen von mindestens zwei Betriebsparametern und von mindestens einer räumlichen Schwingungskomponente der elektrischen rotatorischen Maschine umfassen,
- in den Ist-Daten Betriebsplateaus erkannt werden (S02), wobei ein Betriebsplateau dadurch definiert ist, dass die mindestens zwei Betriebsparameter über einen vorgebbaren Zeitraum konstant sind,
- ein nach einem der Ansprüche 1 bis 4 trainiertes Modell bereitgestellt wird (S03),
- die erkannten Betriebsplateaus den durch das trainierte Modell definierten Betriebszuständen zugeordnet werden (S04), um Zeitreihe der mindestens einen räumlichen Schwingungskomponente auf die durch das trainierte Modell definierten Betriebszustände abbilden zu können,
- überprüft wird (S05), ob Werte der mindestens einen räumlichen Schwingungskomponente einen durch das trainierte Modell empfohlenen Schwellwert überschreiten,
- falls die Werte der mindestens einen räumlichen Schwingungskomponente den Schwellwert überschreiten, eine Warnmeldung nach einem vorbestimmbaren Kriterium ausgegeben wird (S06).

6. Verfahren nach Anspruch 5, wobei, wenn zumindest drei nacheinander folgende Werte der mindestens einen räumlichen Schwingungskomponente den Schwellwert überschreiten, eine Warnmeldung ausgegeben wird.

7. Verfahren nach Anspruch 5 oder 6, wobei die Ist-Daten Zeitreihen von zwei oder drei räumlichen Schwingungskomponenten umfassen, wobei überprüft wird, ob Werte der zwei oder drei räumlichen Schwingungskomponenten entsprechende durch das trainierte Modell empfohlene Schwellwerte überschreiten.

8. Verfahren nach Anspruch 7, wobei für jeden Wert der mindestens einen räumlichen Schwingungskomponente, der den Schwellwert überschreitet, für jede räumliche Schwingungskomponente ein Effektivwert berechnet wird und aus den berechneten Effektivwerten ein geometrisches Mittel berechnet wird, wobei, wenn das geometrische Mittel einen vorgegebenen Wert, beispielsweise 4 mm/s, überschreitet, die Warnmeldung ausgegeben wird.

9. Verfahren nach einem der Ansprüche 5 bis 8, wobei die Warnmeldung eine Anzahl der Überschreitungen und dazugehörige Zeitstempel umfasst.

10. Verfahren nach einem der Ansprüche 5 bis 9, wobei die Zeitreihen der Ist-Daten von bis zu zwei Tagen zurückgehen.

11. Verfahren nach einem der Ansprüche 5 bis 10, wobei die Ist-Daten gespeichert werden und in vorgegebenen Zeitabständen, beispielsweise jeden Monat, das bereitgestellte Modell gemäß einem Verfahren nach einem der Ansprüche 1 bis 4 neutrainiert wird.

12. Computerprogrammprodukt (14) umfassend Befehle, die beim Ausführen durch einen Computer diesen veranlassen, ein Verfahren nach einem der Ansprüche 1 bis 4 und/oder ein Verfahren nach einem der Ansprüche 5 bis 11 auszuführen.

13. Maschinenlesbares Speichermedium (2) umfassend ein Computerprogrammprodukt nach Anspruch 12.

14. Sensor- und Recheneinrichtung (10) zum Überwachen eines Zustandes einer elektrischen rotatorischen Maschine (11), die dazu eingerichtet ist, auf den Betrieb der elektrischen rotatorischen Maschine (11) bezogene Daten an der elektrischen rotatorischen Maschine zu erfassen, wobei die Daten Zeitreihen von mindestens zwei Betriebsparametern und von mindestens einer räumlichen Schwingungskomponente der elektrischen rotatorischen Maschine (11) umfassen, wobei die Sensor- und Recheneinrichtung Mittel zur Ausführung von Befehlen (14) umfasst, die beim Ausführen durch die Sensor- und Recheneinrichtung diese veranlassen, ein Verfahren nach einem der Ansprüche 1 bis 4 und/oder ein Verfahren nach einem der Ansprüche 5 bis 11 auszuführen.

## Claims

1. Computer-implemented method for training a model for recommending threshold values of at least one spatial vibration component of an electric rotary machine, wherein
- historical data is provided (S1), wherein the historical data comprises time series of at least two operating parameters and at least one spatial vibration component of the electric rotary machine, **characterised in that**
- operating plateaus are detected (S2) in the historical data, wherein an operating plateau is defined **in that** the at least two operating parameters are constant over a predeterminable period of time,
- a cluster analysis is performed (S3) on the detected operating plateaus in order to detect operating point clusters, wherein various operating point clusters define various operating states of the electric rotary machine,
- threshold values to be recommended for the defined operating states are determined (S4) for the at least one spatial vibration component,
- the defined operating states and the threshold values to be recommended for the defined operating states are provided (S5).

2. Method according to claim 1, wherein a centre of gravity is estimated for each operating point cluster.

3. Method according to claim 1 or 2, wherein the historical data comprise time series of two or three spatial vibration components, wherein threshold values to be recommended for the two or three spatial vibration components are determined for the defined operating states.

4. Method according to one of claims 1 to 3, wherein the operating parameters are rotational speed and slip frequency.

5. Computer-implemented method for monitoring a status of an electric rotary machine, wherein
- actual data is provided (S01), wherein the actual data comprises time series of at least two operating parameters and at least one spatial vibration component of the electric rotary machine,
- operating plateaus are detected (S02) in the actual data, wherein an operating plateau is defined in that the at least two operating parameters are constant over a predeterminable period of time,
- a model trained according to one of claims 1 to 4 is provided (S03),
- the detected operating plateaus are assigned (S04) to the operating states defined by the trained model in order to be able to map the time series of the at least one spatial vibration component to the operating states defined by the trained model,
- it is checked (S05) whether values of the at least one spatial vibration component exceed a threshold value recommended by the trained model,
- if the values of the at least one spatial vibration component exceed the threshold value, a warning message is output (S06) according to a predeterminable criterion.

6. Method according to claim 5, wherein if at least three successive values of the at least one spatial vibration component exceed the threshold value, a warning message is output.

7. Method according to claim 5 or 6, wherein the actual data comprises time series of two or three spatial vibration components, wherein it is checked whether values of the two or three spatial vibration components exceed corresponding threshold values recommended by the trained model.

8. Method according to claim 7, wherein for each value of the at least one spatial vibration component exceeding the threshold value, an effective value is calculated for each spatial vibration component and a geometric mean is calculated from the calculated effective values, wherein if the geometric mean exceeds a predetermined value, for example 4 mm/s, the warning message is output.

9. Method according to one of claims 5 to 8, wherein the warning message comprises a number of exceedances and associated time stamps.

10. Method according to one of claims 5 to 9, wherein the time series of the actual data go back up to two days.

11. Method according to one of claims 5 to 10, wherein the actual data is stored and the model provided is retrained at predetermined time intervals, for example every month, according to a method according to one of claims 1 to 4.

12. Computer program product (14) comprising commands which, when executed by a computer, cause the computer to carry out a method according to one of claims 1 to 4 and/or a method according to one of claims 5 to 11.

13. Machine-readable storage medium (2) comprising a computer program product according to claim 12.

14. sensor and computing facility (10) for monitoring a status of an electric rotary machine (11) which is designed to detect data relating to the operation of the electric rotary machine (11) on the electric rotary machine, wherein the data comprises time series of at least two operating parameters and of at least one spatial vibration component of the electric rotary machine (11), wherein the sensor and computing facility comprises means for executing commands (14) which, when executed by the sensor and computing facility, cause the latter to carry out a method according to one of claims 1 to 4 and/or a method according to one of claims 5 to 11.

## Revendications

1. Procédé mis en œuvre par ordinateur d'entraînement d'un modèle pour recommander des valeurs de seuil d'au moins une composante spatiale de vibration d'une machine électrique tournante, dans lequel
- on se procure des données historiques (S1),
dans lequel les données historiques comprennent des séries temporelles d'au moins deux paramètres de fonctionnement et d'au moins une composante spatiale de vibration de la machine électrique tournante, **caractérisé en ce qu'**
- on identifie des plateaux de fonctionnement dans les données historiques (S2),
dans lequel un plateau de fonctionnement est défini par le fait que les au moins deux paramètres de fonctionnement sont constants sur un laps de temps pouvant être donné à l'avance,
- sur les plateaux de fonctionnement identifiés, on effectue une analyse de cluster (S3),
afin d'identifier des clusters de points de fonctionnement, dans lequel des clusters de points de fonctionnement différents définissent des états de fonctionnement différents de la machine électrique tournante,
- on détermine pour la au moins une composante spatiale de vibration des valeurs de seuil à recommander pour les états de fonctionnement définis (S4),
- on donne les états de fonctionnement définis et les valeurs de seuil à recommander pour les états de fonctionnement définis (S5).

2. Procédé suivant la revendication 1, dans lequel on estime un barycentre pour chaque cluster de point de fonctionnement.

3. Procédé suivant la revendication 1 ou 2, dans lequel les données historiques comprennent des séries temporelles de deux ou trois composantes spatiales de vibration, dans lequel on détermine, pour les deux ou trois composantes spatiales de vibration, des valeurs de seuil à recommander pour les états de fonctionnement définis.

4. Procédé suivant l'une des revendications 1 à 3, dans lequel les paramètres de fonctionnement sont une vitesse de rotation et une fréquence de glissement.

5. Procédé mis en œuvre par ordinateur de contrôle d'un état d'une machine électrique tournante, dans lequel
- on se procure des données réelles (S01),
dans lequel les données réelles comprennent des séries temporelles d'au moins deux paramètres de fonctionnement et d'au moins une composante spatiale de vibration de la machine électrique tournante,
- on identifie des plateaux de fonctionnement dans des données réelles (S02),
dans lequel un plateau de fonctionnement est défini par le fait que les au moins deux paramètres de fonctionnement sont constants sur un laps de temps pouvant être donné à l'avance,
- on se procure un modèle entraîné suivant l'une des revendications 1 à 4 (S03),
- on affecte les plateaux de fonctionnement identifiés aux états de fonctionnement définis par le modèle entraîné (S04),
pour pouvoir reproduire des séries temporelles de la au moins une composante spatiale de vibration sur les états de fonctionnement définis par le modèle entraîné,
- on contrôle (S05),
si des valeurs de la au moins une composante spatiale de vibration dépassent une valeur de seuil recommandée par le modèle entraîné,
- si les valeurs de la au moins une composante spatiale de vibration dépassent la valeur de seuil, on donne un message d'alerte suivant un critère pouvant être déterminé à l'avance (S06).

6. Procédé suivant la revendication 5, dans lequel, si au moins trois valeurs successives de la au moins une composante spatiale de vibration dépassent la valeur de seuil, on donne un message d'alerte.

7. Procédé suivant la revendication 5 ou 6, dans lequel les données réelles comprennent des séries temporelles de deux ou trois composantes spatiales de vibration, dans lequel on contrôle, si des valeurs des deux ou trois composantes spatiales de vibration dépassent des valeurs de seuil recommandées par le modèle entraîné.

8. Procédé suivant la revendication 7, dans lequel, pour chaque valeur de la au moins une composante spatiale de vibration, qui dépasse la valeur de seuil, on calcule une valeur effective pour chaque composante spatiale de vibration et on calcule une moyenne géométrique à partir des valeurs effectives calculées, dans lequel, si la moyenne géométrique dépasse une valeur donnée à l'avance, par exemple de 4 mm/s, on donne le message d'alerte.

9. Procédé suivant l'une des revendications 5 à 8, dans lequel le message d'alerte comprend un nombre des dépassements et une estampille temporelle, qui lui appartient.

10. Procédé suivant l'une des revendications 5 à 9, dans lequel les séries temporelles des données réelles remontent jusqu'à deux jours.

11. Procédé suivant l'une des revendications 5 à 10, dans lequel on met en mémoire les données réelles et, à des intervalles de temps donnés à l'avance, par exemple chaque mois, on entraîne à nouveau selon un procédé suivant l'une des revendications 1 à 4, le modèle dont on dispose.

12. Produit (14) de programme d'ordinateur comprenant des instructions qui, lors de l'exécution par ordinateur, font que celles-ci exécutent un procédé suivant l'une des revendications 1 à 4 et/ou un procédé suivant l'une des revendications 5 à 11.

13. Support (2) de mémoire, déchiffrable par machine, comprenant un produit de programme d'ordinateur suivant la revendication 12.

14. Dispositif (10) capteur et informatique, pour le contrôle d'un état d'une machine (11) électrique tournante, qui est agencé pour détecter sur la machine électrique tournante des données se rapportant au fonctionnement de la machine (11) électrique tournante, dans lequel les données comprennent des séries temporelles d'au moins deux paramètres de fonctionnement et d'au moins une composante spatiale de vibration de la machine (11) électrique tournante, dans lequel le dispositif capteur et informatique comprend des moyens pour exécuter des instructions (14) qui, lorsqu'elles sont exécutées par le dispositif capteur et informatique, font que celui-ci exécute un procédé suivant l'une des revendications 1 à 4 et/ou un procédé suivant l'une des revendications 5 à 11.
